Europäisches Patentamt

European Patent Office

Office européen des brevets

(19)

(11) Veröffentlichungsnummer: **0 025 574**
**B1**

(12) **EUROPÄISCHE PATENTSCHRIFT**

(45) Veröffentlichungstag der Patentschrift:
**23.03.83**

(21) Anmeldenummer: **80105334.9**

(22) Anmeldetag: **06.09.80**

(51) Int. Cl.³: **G 21 C 3/62,** B 01 J 2/00,
C 23 C 11/00

(54) **Düse zur Zuführung von Gasen.**

(30) Priorität: **18.09.79 DE 2937652**

(43) Veröffentlichungstag der Anmeldung:
**25.03.81 Patentblatt 81/12**

(45) Bekanntmachung des Hinweises auf die Patenterteilung:
**23.03.83 Patentblatt 83/12**

(84) Benannte Vertragsstaaten:
**AT BE FR GB**

(56) Entgegenhaltungen:
**DE-B-2 611 844**
**FR-A-2 229 120**
**GB-A-1 017 089**

(73) Patentinhaber: **Kernforschungsanlage Jülich
Gesellschaft mit beschränkter Haftung, Postfach 1913,
D-5170 Jülich (DE)**

(72) Erfinder: **Barnert, Eike, Dr., Röntgenstrasse 13,
D-5170 Jülich (DE)**

## Düse zur Zuführung von Gasen

Die Erfindung bezieht sich auf eine Düse zur Zuführung von thermisch zersetzbaren Gasen zur Beschichtung von Brennstoff- und Brutstoffkernen für Kernreaktoren sowie der zur Beschichtung erforderlichen Trägergase, bei der ein zentraler Kanal zur Führung der zersetzbaren Gase und ein koaxial zum zentralen Kanal angeordneter Ringkanal zur Führung der Trägergase vorgesehen sind, wobei die den Ringkanal nach außen begrenzende Wandung an ihrem oberen Ende eine Engstelle bildet und die auf gleicher Ebene liegenden Mündungen des auf die Engstelle ausgerichteten zentralen Kanals und des Ringkanals im Abstand von der engsten Stelle der Rohrwandung angeordnet sind. Derartige Düsen sind in der DE-B-2 611 844 beschrieben.

Düsen der vorgenannten Art sind bei Wirbelschichtreaktoren vorgesehen, bei denen sie unterhalb des Fließbettes angeordnet sind. In derartigen Wirbelschichtreaktoren werden beispielsweise Brenn- oder Brutstoffkerne mit einem Durchmesser von einigen 100 µm durch Pyrolyse mit geeigneten Stoffen beschichtet, um bei der Kernspaltung das Freisetzen von Spaltstoffen zu verhindern. Zur Pyrolyse geeignete Gase sind Methan, Propan, Propylen, Chlormethylsilan, Molybdän-V-Chlorid oder dergleichen. Sie werden zusammen mit einem geeigneten Trägergas wie Argon, Helium, Wasserstoff, Stickstoff, Kohlenmonoxid oder dergleichen in das Fließbett eingeleitet. Die Reaktionstemperatur liegt zwischen 1000 und 2200° C.

Bei der vorgenannten Düse ist die von den Beschichtungsgasen durchströmte Wandung des zentralen Kanals im Abstand von der engsten Stelle der äußeren Rohrwandung, die nach oben hin das Fließbett bildet, axial verschiebbar angeordnet. In der DE-B-2 611 844 ist als Durchmesser für die engste Stelle 6 mm angegeben. Sie liegt daher im Inneren der Düse und befindet sich auf einer niedrigeren Temperatur als der für die Zersetzung der Beschichtungsgase erforderlichen Zersetzungstemperatur. Da das Zentralrohr zudem noch gekühlt wird, ist eine Bildung von Abscheidungen aus Beschichtungsmaterial an den die Mündung des zentralen Kanals bildenden Teilen der Düse somit ausgeschlossen. Da ferner der durch den zentralen Kanal auf die Mitte der engsten Stelle der Rohrwandung ausgerichtete Beschichtungsgasstrom bei laminarer Strömung der Gase von dem aus dem Ringkanal austretenden Trägergasstrom seitlich umhüllt und somit von der den Trägergasstrom zur Engstelle leitenden Wandung der Düse ferngehalten wird, wird auch an den übrigen Teilen der Düse die Bildung von Abscheidungen vermieden. Das gilt insbesondere auch für die die engste Stelle der Rohrwandung bildenden Teile der Düse, die sich auf der für die Zersetzung der Beschichtungsgase erforderlichen Temperatur befinden.

In der Praxis wird angestrebt, eine möglichst große Menge an Partikeln in einem Arbeitsgang im Wirbelschichtreaktor zu beschichten. Das bedingt, außer einer Vergrößerung des Fließbettes, um dessen Aufnahmefähigkeit für die größere Menge des Beschichtungsgutes zu erhöhen, eine Erhöhung des pro Zeiteinheit in das Fließbett einzuleitenden Menge an Beschichtungsgas. Das setzt eine entsprechende Vergrößerung der Düse voraus. Dabei stellt sich jedoch das Problem, daß sowohl der Durchmesser des zentralen Kanals als auch der Durchmesser der Engstelle nicht beliebig vergrößert werden können. Denn ein zu großer Durchmesser des zentralen Kanals führt dazu, daß der zentrale Beschichtungsgasstrom »weich« wird und flackert. Ein zu großer Durchmesser der Engstelle führt dagegen zu einer schaukelnden Bewegung des Beschichtungsgutes im Fließbett. Diese schaukelnde Bewegung des Beschichtungsgutes ist nicht nur aus fließtechnischen Gründen unerwünscht, sondern auch deshalb, weil die einzelnen Partikeln bei der schaukelnden Hin- und Herbewegung des Gutes nach oben und unten relativ stark beschleunigt werden, wodurch ein Teil der Partikeln infolge der nach unten gerichteten Beschleunigung das Fließbett durch die Engstelle verläßt und somit diesem Arbeitsgang entzogen werden. Sie sind dann als Ausschuß anzusehen.

Es ist Aufgabe der Erfindung, die Düse der vorgenannten Art derart zu dimensionieren, daß eine möglichst große Menge an Partikeln in einem Arbeitsgang beschichtet werden kann, ohne daß die Düse ihre vorteilhaften Eigenschaften in Hinsicht auf eine Vermeidung von Abscheidungen an Teilen der Düse einbüßt.

Diese Aufgabe wird bei einer Düse der eingangs bezeichneten Art gemäß der Erfindung dadurch gelöst, daß der Durchmesser der Engstelle 3 bis 10 mm beträgt, daß der Durchmesser des zentralen Kanals größer ist als der Durchmesser der Engstelle, wobei das Verhältnis der Größen der beiden Durchmesser den Faktor 3,5 nicht übersteigt und daß der Abstand zwischen den Mündungen der beiden Kanäle und der Engstelle 20 bis 70 mm beträgt.

Da bei der Düse gemäß der Erfindung der Durchmesser der Engstelle kleiner ist als der Durchmesser des zentralen Kanals, wird der laminare Zentralstrahl in der Ebene der Engstelle derart zusammengeschnürt, daß sein Durchmesser beim Durchtritt durch die Engstelle kleiner ist als der Durchmesser der Engstelle. Die Zusammenschnürung hängt allerdings ab von dem Angebot des den Ringstrahl bildenden Trägergases. Und je größer der Ringstrahldurchsatz gewählt wird, desto größer ist die Zusammenschnürung des Zentralstrahles.

Es hat sich überraschenderweise gezeigt, daß die Zusammenschnürung des Zentralstrahles keineswegs zu einer Reduzierung des Durchsatzes — etwa durch früher eintretende Turbulenz — führt. Vielmehr kann bei der Einstellung des im Hinblick auf eine laminare Strömung (Re 2300) maximal möglichen Durchsatzes der Durchmesser der Engstelle in den angegebenen Grenzen praktisch außer Acht bleiben.

Dieser Umschlag erfolgt mit und ohne Zusammenschnürung bei gleicher Reynoldsscher Zahl des Zentralstrahles

$$Re_Z = \frac{u_Z \cdot d_Z \cdot \rho_Z}{\eta_Z}$$

$u_Z$: Geschwindigkeit des den Zentralstrahl bildenden Fluides beim Verlassen des Zentralkanals

$d_Z$: Durchmesser des Zentralstrahles bei Verlassen des Zentralkanals

$\rho_Z$: Dichte des den Zentralstrahl bildenden Fluides

$\eta_Z$: Dynamische Zähigkeit des den Zentralstrahl bildenden Fluides

Die Erfindung gibt somit die Lehre, durch welche Maßnahmen und innerhalb welcher Grenzen der Durchsatz des Gases bei noch hinreichend kleinem Durchmesser der Engstelle erhöht werden kann, ohne daß der Umschlag der Gasströmung des Zentralstrahles von Laminarität zur Turbulenz erfolgt.

Die Düse gemäß der Erfindung ist einsetzbar für eine Beschichtung von Partikeln, deren Dichte im Bereich von etwa 4 bis etwa 10 g/cm³ und deren Durchmesser im Bereich von etwa 200 bis etwa 500 µm liegt. Dabei ist es zweckmäßig, daß für den Fall, daß Partikeln einer Dichte von etwa 10 g/cm³ und einem Durchmesser von etwa 200 µm beschichtet werden sollen, der Durchmesser der Engstelle nicht größer ist als 6 mm.

Ein Ausführungsbeispiel der Düse gemäß der Erfindung ist in der Zeichnung schematisch dargestellt und wird in folgendem näher erläutert. Anhand der in der Zeichnung ebenfalls wiedergegebenen Diagramme wird darüber hinaus die Arbeitsweise der Düse wiedergegeben. Es zeigt

Fig. 1 einen Querschnitt durch die Düse,

Fig. 2 das Diagramm einer Versuchsreihe, bei der die Düse ein Zentralrohr aufwies, das aus einem Rohrbündel aus sieben Rohren bestand und

Fig. 3 das Diagramm einer Versuchsreihe, bei der die Düse ein aus 19 Rohren bestehendes Rohrbündel als Kanalrohr aufwies,
wobei die Diagramme den für einen bestimmten Durchsatz des zentralen Strahls erforderlichen Durchsatz des Ringstrahls angeben, der eine solche Zusammenschnürung des Zentralstrahles in der Ebene der Engstelle ergibt, daß gerade keine Benetzung der die Engstelle bildenden Teile mit Reaktionsgas erfolgt. Das bei den Versuchsreihen verwendete Fluid war Luft.

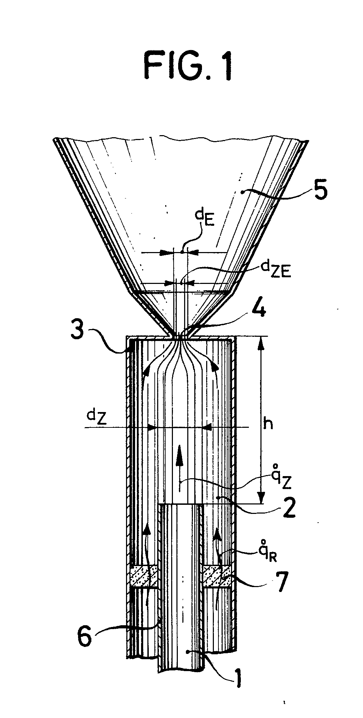

Wie aus Fig. 1 hervorgeht, weist die Düse einen zentralen Kanal 1 und einen den zentralen Kanal umgebenden Ringkanal 2 auf. Die den Ringkanal 2 begrenzende Wandung 3 mündet in die Engstelle 4 mit dem Durchmesser $d_E$, die zugleich den unteren Abschluß des in der Zeichnung nur teilweise dargestellten Fließbettes 5 bildet. Die Mündung des den inneren Kanal 1 bildenden Innenrohres 6 liegt im Abstand h von der Engstelle 4 und befindet sich daher nicht auf der zur Zersetzung des Beschichtungsgases erforderlichen Temperatur.

Der den zentralen Kanal 1 verlassende Beschichtungsgasstrom sowie der den Ringkanal 2 verlassende Trägergasstrom gelangt bei laminarer Strömung quasi in getrennten Strömungsbahnen zur engsten Stelle 4 der Rohrwandung, wobei das Material der engsten Stelle nur von inertem Trägergas umspült wird. Dabei hat der zentrale Strahl nach Verlassen des zentralen Rohres zunächst den Durchmesser $d_Z$, wird jedoch bis zur Engstelle auf den Durchmesser $d_{ZE}$ zusammengeschnürt.

Zur Erzeugung einer gleich verteilten Geschwindigkeit des den Ringkanal verlassenden Trägergases ist im Ringkanal eine eine poröse Schicht bildende, ringförmig ausgebildete Platte 7 aus porösem Grafit oder Sintermetall vorgesehen, die zugleich als Halterung für das in axialer Richtung verschiebbare Innenrohr dient. Dadurch, daß das Trägergas durch die poröse Schicht 7 hindurchgeleitet wird, wird ein weitgehend uniformes Geschwindigkeitsprofil im Trägergasstrom erzielt.

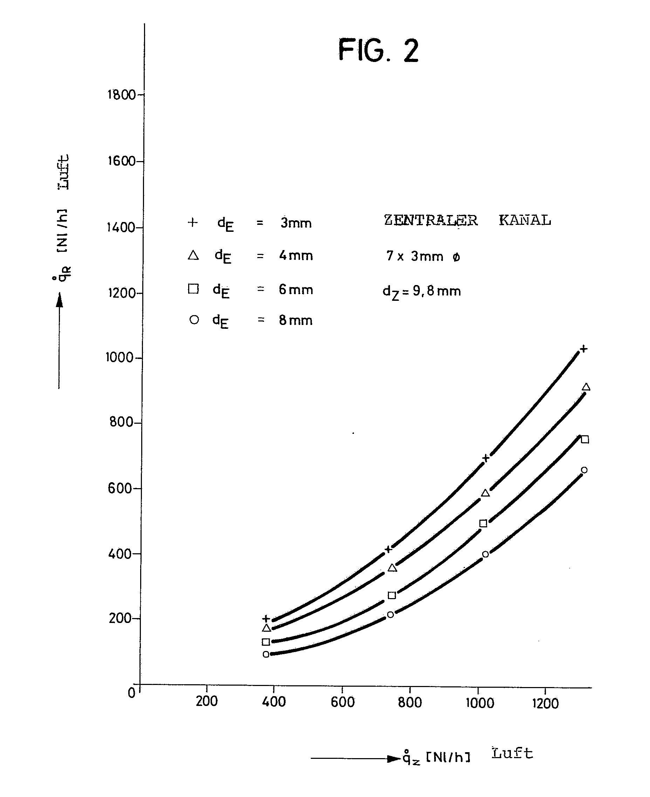

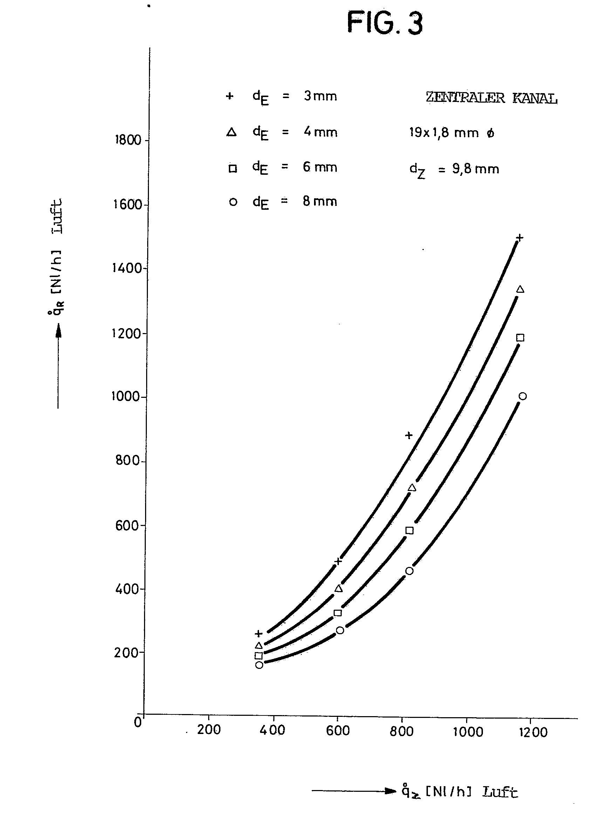

Aus den in Fig. 2 und 3 wiedergegebenen Diagrammen ist für die beiden vorgenannten Ausführungsformen des zentralen Kanals (unterschiedliche Rohrbündel) ablesbar, welcher minimale Durchsatz $\dot{q}_R$ des Ringstrahls bei Vorgabe eines bestimmten Durchsatzes $\dot{q}_Z$ bei Verwendung der Düse einzustellen ist. Der Durchmesser $d_Z$ des zentralen Kanals betrug in beiden Fällen je 9,8 mm, wobei im Falle des aus sieben Rohren bestehenden Rohrbündels der Durchmesser eines einzelnen Rohres 3 mm, im Falle des aus 19 Rohren bestehenden Rohrbündels der Durchmesser eines einzelnen Rohres 1,8 mm betrug. Die verschiedenen Durchmesser $d_E$ der Engstelle waren 3, 4, 6 und 8 mm, der Abstand h der Mündung des zentralen Kanals von der Engstelle 50 mm und der Ringstrahldurchmesser 26 mm.

Zur Beladung des Fließbettes wurden 250 ml Harzpartikeln mit einem Durchmesser im Bereich zwischen 200 bis 300 µm und einer Dichte von 1,5 g/cm³ vorgesehen.

Aus den Angaben der Durchsätze $\dot{q}_R$ und $\dot{q}_Z$ in den vorgenannten Diagrammen können selbstverständlich über die Reynoldschen Zahlen die Durchsätze für entsprechend andere, beliebige Gase umgerechnet werden.

**Patentansprüche**

1. Düse zur Zuführung von thermisch zersetzbaren Gasen zur Beschichtung von Brennstoff- und Brutstoffkernen für Kernreaktoren sowie der zur Beschichtung erforderlichen Trägergase, bei der ein zentraler Kanal zur Führung der zersetzbaren Gase und ein koaxial zum zentralen Kanal angeordneter Ringkanal zur Führung der Trägergase vorgesehen sind, wobei die den Ringkanal nach außen begrenzende Rohrwandung an ihrem oberen Ende eine Engstelle bildet und die auf gleicher Ebene liegenden Mündungen des auf die Engstelle ausgerichteten zentralen Kanals und des Ringkanals im Abstand von der engsten Stelle der Rohrwandung angeordnet sind, dadurch gekennzeichnet, daß der Durchmesser ($d_E$) der Engstelle (4) 3 bis 10 mm beträgt, daß der Durchmesser ($d_Z$) des zentralen Kanals (1) größer ist als der Durchmesser ($d_E$) der Engstelle, wobei das Verhältnis der Größen der beiden Durchmesser den Faktor 3,5 nicht übersteigt und daß der Abstand zwischen den Mündungen der beiden Kanäle und der Engstelle 20 bis 70 mm beträgt.

2. Düse nach Anspruch 1, dadurch gekennzeichnet, daß für den Fall, daß Partikeln einer Dichte von etwa 10 g/cm³ und einem Durchmesser von etwa 200 µm beschichtet werden sollen, der Durchmesser ($d_E$) der Engstelle (4) nicht größer ist als 6 mm.

## Claims

1. Nozzle for feeding gases, which are decomposable thermally, for coating fuel cores and fertile material cores for nuclear reactors, and for feeding the carrier gases necessary for coating, in which nozzle a central channel is provided for guiding the decomposable gases and an annular channel arranged coaxially to the central channel is provided for guiding the carrier gases, and the pipe wall delimiting the annular channel towards the outside forms a constriction at its upper end and the openings, located in the same plane, of the central channel pointing to the constriction and of the annular channel being arranged at a distance from the narrowest point of the pipe wall, characterised in that the diameter ($d_E$) of the constriction (4) is 3 to 10 mm, that the diameter ($d_Z$) of the central channel (1) is greater than the diameter ($d_E$) of the constriction, the size ratio of the two diameters not exceeding the factor 3.5, and that the distance between the openings of the two channels and the constriction is 20 to 70 mm.

2. Nozzle according to claim 1, characterised in that, when particles of a density of about 10 g/cm³ and a diameter of about 200 µm have to be coated, the diameter ($d_E$) of the constriction (4) is not greater than 6 mm.

## Revendications

1. Buse pour l'amenée de gaz décomposables par voie thermique pour l'enrobage de noyaux de matière combustible et fertile destinés à des réacteurs nurcléaires, ainsi que des gaz porteurs nécessaires à l'enrobage, dans laquelle sont prévus un canal central pour le guidage des gaz décomposables et un canal annulaire coaxial au canal central pour le guidage des gaz porteurs, la paroi tubulaire délimitant le canal annulaire vers l'extérieur formant à son extrémité supérieure un étranglement et les embouchures, se trouvant dans le même plan, du canal central et du canal annulaire dirigés sur l'étranglement étant disposées à distance de l'endroit le plus étroit de la paroi tubulaire, caractérisée en ce que le diamètre ($d_E$) de l'étranglement (4) est compris entre 3 et 10 mm, en ce que le diamètre ($d_Z$) du canal central (1) est plus grand que le diamètre ($d_E$) de l'étranglement, le rapport des valeurs des deux diamètres ne dépassant pas le facteur 3,5, et en ce que la distance entre les embouchures des deux canaux et l'étranglement est comprise entre 20 et 70 mm.

2. Buse suivant la revendication 1, caractérisée en ce que, dans le cas où l'on doit enrober des particules d'une masse volumique de 10 g/cm³ environ et d'un diamètre de 200 microns environ, le diamètre ($d_E$) de l'étranglement (4) n'est pas supérieur à 6 mm.

# FIG. 1

FIG. 2

# FIG. 3